# EUROPEAN PATENT SPECIFICATION

(11) **EP 0 811 993 B1**
(45) Date of publication and mention of the grant of the patent: **17.09.2003**
(21) Application number: 97202527.4
(22) Date of filing: 08.07.1993
(51) Int. Cl.: H01C 1/14, H05K 1/18

(54) **Electrical devices**
Elektrische Bauelemente
Dispositifs électriques

(30) Priority: 09.07.1992 US 910950
(43) Date of publication of application: 10.12.1997
(62) Divisional of application: 93917069.2
(73) Proprietor: Tyco Electronics Corporation, Middletown, PA 17057-3163 (US)
(72) Inventor: Graves, Gregory A., Troy, MI 48098 (US); Zhang, Michael, Fremont, CA 94555 (US); Chandler, Daniel, Menlo Park, CA 94025 (US); Chang, Chi-Ming, Clear Water Bay, Kowloon, Hong Kong (CN); Fang, Shou-Mean, Union City, CA 94587 (US)
(74) Representative: Jay, Anthony William

(56) References cited:
- EP-A- 0 398 811
- GB-A- 1 415 454
- US-A- 3 497 859
- US-A- 4 475 138
- US-A- 4 924 204

## Description

This invention relates to electrical circuit protection devices.

Many electrical devices comprise two laminar electrodes and, sandwiched between them, an electrical element which may be a conductor, e.g. a resistive element, as for example in a resistor or a varistor, or a non-conductor, as for example in a capacitor. Particularly useful devices of this type are circuit protection devices which comprise a main portion which is a laminate of two laminar electrodes and, sandwiched between the electrodes, a laminar resistive element which exhibits PTC behavior. The resistive element may be composed of conductive polymer (this term being used to denote a composition comprising a polymer and, dispersed therein, a particulate conductive filler) or a ceramic, e.g. a doped barium titanate. When a conductive polymer is used, such devices are generally prepared by stamping (or otherwise cutting) a plurality of the devices out of a laminate of a sheet of the conductive polymer between two metal foils. When a ceramic is used, such devices are usually prepared by applying liquid electrode material to the major surfaces of a preformed laminar resistive element, and solidifying the liquid electrode material.

The products of such processes can sometimes be used without the addition of electrical leads, for example by installation between two spring-loaded terminals. In most cases, however, an electrical lead must be secured to each of the laminar electrodes, so that the device can be connected to other components of a circuit, e.g. mounted on a circuit board. The addition of leads is an additional expense and usually involves heating (e.g. during soldering or welding) which can cause damage, particularly to conductive polymer elements. The latter problem is particularly severe when a conductive polymer is heated a second time when the leads are connected to other circuit elements, in particular when the leads are connected to a printed circuit board by a soldering process. A further problem which can arise when such devices are to be mounted on a printed circuit board is that they protrude further from the board than is desirable.

DE-A-3839868 patent document of patent US-A-4 924 204 describes laminar PTC devices composed of a conductive polymer, which are electrically connected to other components of a circuit through terminal members which elastically engage "non-electrode regions" of the device. Each of the non-electrode regions comprise one only of the two electrodes and a corresponding portion of the PTC element.

US-A-3497859 discloses electrical resistors for use in printed circuits. The resistors are designed for insertion into a printed circuit board, with legs having a wedge shape.

We have now realized, in accordance with the present invention, that when at least one of the laminar electrodes of an electrical device as described above is to be connected to an electrical conductor on an insulating substrate, in particular a printed circuit board, then by appropriate modification of the device and/or of the configuration of the electrical conductor on the substrate, the connection can be made either without the need for a lead (or other connecting member), or with the aid of a connecting member which is electrically connected to the electrode in the same step as it is electrically connected to the conductor on the substrate. We have also realized in accordance with the present invention, that such modification can also be extremely valuable for electrical devices which are connected via elastically deformed terminals. The invention will be described herein chiefly by reference by circuit protection devices, but it is also applicable to other devices comprising two laminar electrodes and a laminar element sandwiched between them.

One device of the invention has, in addition to a main portion having its normal configuration (typically a simple geometric shape such as a rectangle or a circle), at least one connection leg which extends away from the main portion and which comprises an extension of the PTC resistive element and an extension of one of the electrodes secured to the PTC element, and optionally also an extension of the other electrode. Such a modified device can be mounted on a circuit board by inserting the end of the connection leg into an aperture in the board and soldering the electrode to a metal conductor which is secured to the board and which leads to the aperture. If the connection leg does not include both electrodes, then the solder connection can be carried out in conventional ways. If the leg does include both electrodes in the region of the aperture, then care must be taken to ensure that the solder connects only the desired electrode to the metal conductor. For this purpose, the metal conductor can lead to one side only of the aperture and preferably can be substantially narrower than the aperture and the face of the connection leg to which it is soldered. A circuit board having a metal conductor and an aperture of this kind is believed to be novel per se and as such forms a part of the present invention. Generally, a device which is to be mounted in this way will be modified so that it has two connection legs of the kind described, extending in the same direction from the main part of the device, so that the legs can be mounted in adjacent apertures in the same circuit board. The legs preferably have distal portions which are inserted into the apertures in the board, and intermediate stand-off portions which cannot pass through the apertures and which ensure that the main part of the device is spaced apart from the board.

As discussed above (and in greater detail below), when the device is to be mounted in apertures in a circuit board, the connection leg can comprise both electrodes; preferably, however, the connection leg includes a bridge portion which extends across the full width of the leg and which includes only one of the electrodes, so that the device can be soldered to the circuit board in the conventional way. When the connection leg is of the latter kind, the device can also be mounted flat on top of a circuit board in the following way. The device is placed on the substrate with the electrode which extends into the connection leg on top. A bottom electrode is connected directly to a conductor on the board. The top electrode is connected to another conductor on the board by means of a connection member secured to the top electrode and extending downwards below the lower face of the resistive element. The connection member can be soldered or otherwise electrically connected to the upper electrode before it is electrically connected to the conductor on the board.; alternatively, both electrical connections are made simultaneously so that the resistive element is not exposed twice to the heating required to make such connections. In this method, only one connection leg is necessary, because the lower electrode is already adjacent to the board However, if there are two connection legs, the device can be placed on the board with either electrode on top, and the connections to the device and the subsequent operation of the device can be the same.

The novel devices of the invention can be made by securing electrodes of appropriate shapes to resistive elements of the desired final shape; or by securing electrode precursors of appropriate shapes to resistive elements which are larger than the desired final shape, and then cutting out a plurality of devices of the desired final shape or shapes; or by cutting out a plurality of devices of the desired final shape or shapes from a simple laminate of constant cross-section and, if desired or necessary, and before or after the cutting out operation, removing unwanted portions of one or both of the electrodes. Such removal can be effected for example by milling or by etching. Preferably such removal of unwanted portions of the electrodes removes little or none of the PTC resistive element, which provides desirable physical strength to the connection leg. Preferably also, when, as is preferred, the connection leg includes only one of the electrodes, the leg does also include a residual portion of the second electrode. The residual portion is not electrically connected to the main portion, but provides valuable physical properties, including strength and resistance to deformation when connection to the first electrode is made by a spring clip or other elastically deformed terminal.

### A BRIEF DESCRIPTION OF THE DRAWING

The invention is illustrated by the drawing, in which
Figure 1 shows a plan view of an electrical assembly of the invention showing an electrical device of the invention mounted on a circuit board;
Figure 2 is a cross-sectional view of an assembly of the invention along line 2-2 of Figure 1;
Figure 3 is a plan view of another electrical assembly of the invention showing an electrical device of the invention mounted on a circuit board;
Figure 4 is a cross-sectional view of an assembly of the invention along line 4-4 of Figure 3;
Figures 5 is a bottom view of the assembly of Figure 3;
Figure 6 is a top view of another assembly of the invention which includes an electrical device of the invention; and
Figure 7 is a cross-sectional view of an assembly of the invention through the thickness of the assembly of Figure 6.

### DETAILED DESCRIPTION OF THE INVENTION

All embodiments and aspects of the invention set out below are to be regarded as part of Applicants' invention, even where the following detailed description is broader than the summary of the invention set out above.

### PTC Compositions

The PTC compositions used in the present invention are preferably conductive polymers which comprise a crystalline polymer component and, dispersed in the polymer component, a particulate filler component which comprises a conductive filler, e.g. carbon black or a metal. The filler component may also contain a non-conductive filler, which changes not only the electrical properties of the conductive polymer but also its physical properties. Suitable conductive polymers for use in this invention are disclosed for example in U.S. Patent Nos. 4,237,441 (van Konynenburg et al), 4,304,987 (van Konynenburg), 4,388,607 (Toy et al), 4,514,620 (Cheng et al), 4,534,889 (van Konynenburg et al), 4,545,926 (Fouts et al), 4,560,498 (Horsma et al), 4,591,700 (Sopory), 4,724,417 (Au et al), 4,774,024 (Deep et al), 4,935,156 (van Konynenburg), and 5,049,850 (Evans et al), and copending, commonly assigned U.S: Patent Application No. 07/893,626 (Chandler et al, filed June 5, 1992).

The resistive element can be composed of one or more conductive polymer members, at least one of which is a PTC member. When there is more than one conductive polymer member, the current preferably flows sequentially through the different compositions, as for example when each composition is in the form of a layer which extends across the whole of the main portion of the device. When there is a single PTC composition, and the desired thickness of the PTC element is greater than that which can conveniently be prepared in a single step, a PTC element of the desired thickness can conveniently be prepared by joining together, eg. laminating by means of heat and pressure, two or more layers, eg. melt-extruded layers, of the PTC composition. When there is more than one PTC composition, the PTC element will usually be prepared by joining together, eg. laminating by means of heat and pressure, elements of the different compositions. For example, a PTC element can comprise two laminar elements composed of a first PTC composition and, sandwiched between them, a laminar element composed of a second PTC composition having a higher resistivity than the first.

When a PTC device is tripped, most of the voltage dropped over the device is normally dropped over a relatively small part of the device which is referred to as the hot line, hot plane or hot zone. In the devices of the invention, the PTC element can have one or more features which help the hot line to form at a desired location, usually spaced apart from both electrodes. Suitable features of this kind for use in the present invention are disclosed for example in U.S. Patents Nos. 4,317,027 and 4,352,083 (Middleman et al), 4,907,340 and 4,924,072 (Fang et al), the disclosures of which are incorporated herein by reference.

### Laminar Electrodes

Particularly useful devices of the invention comprise two metal foil electrodes, and a PTC conductive polymer element sandwiched between them, especially such devices which are used as circuit protection devices and have low resistance at 23°C, generally less than 50 ohm, preferably less than 10 ohm, particularly less than 5 ohm, especially less than 3 ohm. Particularly suitable foil electrodes are disclosed in U.S. Patents Nos. 4,689,475 (Matthieson) and 4,800,253 (Kleiner et al), the disclosure of each of which is incorporated herein by reference. A variety of laminar devices which can be modified in accordance with the present invention are disclosed in U.S. Patent Nos. 4,238,812 (Middleman et al), 4,255,798 (Simon), 4,272,471 (Walker), 4,315,237 (Middleman et al), 4,317,027 (Middleman et al), 4,330,703 (Horsma et al), 4,426,633 (Taylor), 4,475,138 (Middleman et al), 4,472,417 (Au et al), 4,780,598 (Fahey et al), 4,845,838 (Jacobs et al), 4,907,340 (Fang et al), and 4,924,074 (Fang et al), the disclosure of each of which is incorporated herein by reference.

The present invention provides an electrical circuit protection device which comprises
(1) a first laminar electrode;
(2) a second laminar electrode; and
(3) a laminar resistive element which exhibits PTC behavior, and which has a first face to which the first electrode is secured and an opposite second face to which the second electrode is secured;
the device comprising
(a) a main portion which comprises
   (i) a main part of the first electrode,
   (ii) a main part of the second electrode, and
   (iii) a main part of the resistive element;
   and
(b) a first connection leg which extends away from the main portion and which comprises
   (i) a first leg part of the first electrode which is integral with the main part of the first electrode, and
   (ii) a first leg part of the resistive element which is integral with the main part of the resistive element.
The first connection leg can also include a first leg part of the second electrode which is integral with the main part of the second electrode. Preferably, however, the first connection leg includes a residual part of the second electrode which is not connected to the main part of the second electrode and which does not, therefore, play any part of the electrical operation of the device, alternatively, the first leg can consist essentially of the first leg part of the first electrode and the first leg part of the resistive element.

### First Embodiment of the First aspect of the Invention

In this embodiment, the device is designed to be mounted in apertures of a substrate, e.g. a printed circuit board.

The devices of this embodiment preferably also contain
(c) a second connection leg which extends away from the main portion, which is spaced away from the first connection leg, and which comprises
   (i) a second leg part of the second electrode which is integral with the main part of the second electrode, and
   (ii) a second leg part of the resistive element which is integral with the main part of the resistive element.
The second leg can include a second leg part of the first electrode, but preferably includes only a residual part of the first electrode which provides useful physical properties but does not play any part in the electrical operation of the device. Alternatively the second leg can consist essentially of the second leg part of the second electrode and the second leg part of the resistive element. The main portion and the first and second connection legs are preferably substantially coplanar. However, one or both of the legs (or the sole leg, when there is only one) can be inclined to main portion. Generally each of the legs will extend away from the main portion by a distance of at least 0.15 cm, e.g. 0.15 to 1.0 cm, preferably 0.2 to 0.6 cm.

The first and second connection legs preferably extend away from the main portion in substantially the same direction so that they can both be mounted on a planar substrate, with the main portion of the device extending away from the substrate, preferably at right angles thereto.

In these devices, it is preferred that the first connection leg comprises a first distal sub-portion spaced away from the main portion of the device and a first stand-off sub-portion which lies between the first distal sub-portion and the main portion, and the second connection leg comprises a second distal sub-portion spaced away from the main portion of the device and a second stand-off sub-portion which lies between the second distal sub-portion and the main portion, with the distal and stand-off sub-portions being shaped so that when each of the distal sub-portions is placed in an aperture of an appropriate size in the planar substrate, the stand-off sub-portions will not pass through the apertures and will prevent contact between the substrate and the main portion of the device. Thus one or (preferably) both of the first and second connection legs can be wedge-shaped or can include a step which lies at the junction between the distal and stand-off sub-portions.

When the device is prepared merely by cutting it out from a uniform laminate of the electrode materials and the resistive material, the device will be one in which (a) the first leg part of the first electrode, the first leg part of the resistive element, and a first leg part of the second electrode are substantially coextensive, and (b) a second leg part of the first electrode, the second leg part of the resistive element, and the second leg part of the second electrode are substantially coextensive.

In some cases, however, it is preferred that the device should be one in which the first stand-off sub-portion comprises a first bridge sub-portion which extends across the width of the first connection leg and which does not include any part of the second electrode; and the second stand-off sub-portion comprises a second bridge sub-portion which extends across the width of the second connection leg and does not include any part of the first electrode. Such a device can be prepared by removing a portion of the second electrode from the first connection leg and by removing a portion of the first electrode from the second electrode leg, to give a device in which the first distal sub-portion comprises a second residual conductive member which, in the absence of the first bridge sub-portion, would be integral with the main part of the second electrode; and the second distal sub-portion comprises a first residual conductive member which, in the absence of the second bridge sub-portion, would be integral with the main part of the first electrode. In a device prepared in this way, the second residual conductive member is preferably separated from the second electrode by a distance which is at least as great as the minimum distance between the first and second electrodes at any location on the device, e.g. 1.5 to 4 times that distance, and the first residual conductive member is preferably separated from the first electrode by a distance which is at least as great as the minimum distance between the first and second electrodes at any location on the device, e.g. 1.5 to 4 times that distance. The portion of the electrode which is removed can have a simple shape, e.g. a rectangular strip, or a more complex shape. We have found that the physical strength of the leg can be improved by removing a more complex shape, e.g. a V-shaped portion, of the electrode.

Such a device can also be prepared by removing all of the second electrode from the first connection leg and all of the first electrode from the second connection leg, or by using corresponding preshaped electrodes, in which case the first connection leg is free from any conductive member which, in the absence of the first bridge sub-portion, would be integral with the main part of the second electrode; and the second connection leg is free from any conductive member which, in the absence of the second bridge sub-portion, would be integral with the main part of the first electrode.

### Second Embodiment of the First aspect of the Invention

In this embodiment, the device is designed to be mounted parallel to, preferably spaced apart by a small distance from, a substrate, e.g. a printed circuit board.

In the devices of this embodiment, the first connection leg comprises
(i) a first distal sub-portion which
   (a) is spaced away from the main portion of the device.
   (b) comprises a first distal sub-part of the first leg part of the first electrode, and
   (c) comprises a first electrical connector which contacts the first distal sub-part of the first electrode and extends at least to the second face of the laminar resistive element;
   and
(ii) a first bridge sub-portion which
   (a) lies between the first distal sub-portion and the main portion of the device,
   (b) extends across the width of the first connection leg, and
   (c) does not include any part of the second electrode;
whereby the device can be placed flat on a planar insulating substrate having first and second appropriately spaced-apart metal conductors on the surface thereof, with the first electrical connector adjacent the first metal conductor; and electrical connection can be made (a) between the first metal conductor and the first electrode, through the first electrical connector, and (b) between the second conductor and the second electrode.

Such a device can be made by removing a strip of the second electrode from the first connection leg, to give a device in which the first distal sub-portion comprises a second residual conductive member which is on the second face of the first leg part of the resistive element and which, in the absence of the first bridge sub-portion, would be integral with the main part of the second electrode.

The first electrical connector is preferably one which will remain in place even if it is not bonded to the other parts of the device, for example a U-shaped member which extends around the end of the first leg portion and the first electrode and, if present, the second residual conductive member. The connector can be resilient so that it clamps to the remainder of the device.

So that the device can be placed either way up on the substrate, and/or so that it has balanced electrical properties, the device preferably also contains a second connection leg which extends away from the main portion of the device; which is spaced apart from the first connection leg; which comprises
(i) a second leg part of the second electrode which is integral with the main part of the second electrode, and
(ii) a second leg part of the resistive element which is integral with the main part of the resistive element;
   and which comprises
(iii) a second distal sub-portion which
   (a) is spaced apart from the main portion of the device,
   (b) comprises a second distal sub-part of the second leg part of the second electrode, and
   (c) comprises a second electrical connector which contacts the second distal sub-part of the second electrode and extends at least to the first face of the laminar resistive element;
   and
(iv) a second bridge sub-portion which
   (a) lies between the second distal sub-portion and the main portion of the device,
   (b) extends across the width of the second connection leg, and
   (c) does not include any part of the first electrode;
whereby the device can be placed flat on a planar insulating substrate having first and second appropriately spaced apart metal conductors on the surface thereof, with either the first electrical connector or the second electrical connector adjacent one of the metal conductors, and electrical connection can be made between (a) said electrical connector and metal conductor and (b) the other metal conductor and the electrode adjacent to the substrate.
The preferred characteristics of the second distal and bridge sub-portions and the second connection part are substantially the same as previously described for the first distal and bridge sub-portions and the first connector.

In these devices the contacting surfaces are preferably coated with solder or tin, or otherwise treated, so that they can all be soldered together in a single step by exposing them to heat.

### Assemblies of the Invention

### First embodiment

In this aspect, the invention provides an electrical assembly which comprises
(A) an insulating substrate having a first aperture therein;
(B) a first metal conductor secured to the insulating substrate and leading to the first aperture; and
(C) an electrical device which comprises
   (1) a first laminar electrode;
   (2) a second laminar electrode; and
   (3) a laminar resistive element which exhibits PTC behavior and which has a first face to which the first electrode is secured and an opposite second face to which the second electrode is secured;
   the device comprising
   (a) a main portion which comprises
      (i) a main part of the first electrode,
      (ii) a main part of the second electrode, and
      (iii) a main part of the resistive element;
      and
   (b) a first connection leg
      which extends away from the main portion,
      which comprises
      (i) a first leg part of the first electrode which is integral with the main part of the first electrode, and
      (ii) a first leg part of the resistive element which is integral with the main part of the resistive element, and
   which has a first distal sub-portion spaced away from the main portion of the device and a first stand-off sub-portion between the first distal sub-portion and the main portion;
the first distal sub-portion including a first distal sub-part of the first electrode and lying within the first aperture of the substrate;
the first stand-off sub-portion lying between the substrate and the main portion of the device;
the first metal conductor being physically and electrically connected to the first distal sub-part of the first electrode; and
all of the electrical current between the first metal conductor and the second electrode of the device passing through the first electrode and the resistive element

Preferably the insulating substrate has a second aperture therein; a second metal conductor is secured to the insulating substrate and leads to the second aperture; and the device also contains a second connection leg which
(a) extends away from the main portion,
(b) is spaced away from the first connection leg,
(c) comprises
   (i) a second leg part of the second electrode which is integral with the main part of the second electrode, and
   (ii) a second leg part of the resistive element which is integral with the main part of the resistive element, and
(d) has a second distal sub-portion spaced away from the main portion of the device and a second stand-off sub-portion between the second distal sub-portion and the main portion;
the second distal sub-portion including a second distal sub-part of the second electrode and lying within the second aperture of the substrate;
the second metal conductor being physically and electrically connected to the second distal sub-part of the second electrode; and
all of the electrical current between the second metal conductor and the first electrode of the device passing through the second electrode and the resistive element.

In one preferred assembly, the first leg part of the first electrode, the first leg part of the resistive element, and the first leg part of the second electrode are substantially coextensive; the second leg part of the first electrode, the second leg part of the resistive element, and the second leg part of the second electrode are substantially coextensive; the first conductor terminates on one side of the first aperture and is connected by a first solder joint to the first leg part of the first electrode, with the distance between any part of the first solder joint and the second electrode being at least as great as the minimum distance between the first and second electrodes at any location on the device, e.g. 1.5 to 4 times that distance; and the second conductor terminates on one side of the second aperture and is connected by a second solder joint to the second leg part of the second electrode, with the distance between any part of the second solder joint and the first electrode being at least as great as the minimum distance between the first and second electrodes at any location on the device, e.g. 1.5 to 4 times that distance.

In another preferred assembly
(a) the first stand-off sub-portion comprises a first bridge sub-portion which extends across the width of the first connection leg and which does not include any part of the second electrode
(b) the second stand-off sub-portion comprises a second bridge sub-portion which extends across the width of the second connection leg and does not include any part of the first electrode;
(c) the first distal sub-portion comprises a second residual conductive member which, in the absence of the first bridge sub-portion, would be integral with the main part of the second electrode;
(d) the second distal sub-portion comprises a first residual conductive member which, in the absence of the second bridge sub-portion, would be integral with the main part of the first electrode; and
(e) the first conductor is connected by a first solder joint to the first leg part of the first electrode, with the distance between any part of the first solder joint and the second electrode being at least as great as the minimum distance between the first and second electrodes at any location on the device; and the second conductor is connected by a second solder joint to the second leg part of the second electrode, with the distance between any part of the second solder joint and the first electrode being at least as great as the minimum distance between the first and second electrodes at any location on the device.

### Second embodiment

In this aspect, the invention provides an electrical assembly which comprises
(A) a planar insulating substrate;
(B) a first metal conductor secured to the insulating substrate;
(C) a second metal conductor secured to the insulating substrate; and
(D) an electrical device which comprises
   (1) a first laminar electrode;
   (2) a second laminar electrode; and
   (3) a laminar resistive element which exhibits PTC behavior and which has a first face to which the first electrode is secured and an opposite second face to which the second electrode is secured;
   the device comprising
   (a) a main portion which comprises
      (i) a main part of the first electrode,
      (ii) a main part of the second electrode, and
      (iii) a main part of the resistive element;
      and
   (b) a first connection leg
      which extends away from the main portion,
      which comprises
      (i) a first leg part of the first electrode which is integral with the main part of the first electrode,
      (ii) a first leg part of the resistive element which is integral with the main part of the resistive element,
      (iii) a first distal sub-portion which
         is spaced away from the main portion of the device, comprises a first distal sub-part of the first leg part of the first electrode, and
         comprises a first electrical connector which contacts the first distal sub-part of the first electrode and extends beyond the second face of the laminar resistive element;
      and
   (iv) a first bridge sub-portion which
      lies between the first distal sub-portion and the main portion of the device,
      extends across the width of the first connection leg, and
      does not include any part of the second electrode;
the device being placed generally parallel to the planar insulating substrate with the second electrode being closer to the substrate than the first electrode, the first electrical connector being connected to the first metal conductor; and the second electrical conductor being connected to the second electrode.

In such an assembly, the device preferably also contains a second connection leg which extends away from the main portion of the device; which is spaced apart from the first connection leg; which comprises
(i) a second leg part of the second electrode which is integral with the main part of the second electrode, and
(ii) a second leg part of the resistive element which is integral with the main part of the resistive element;
and which comprises
(i) a second distal sub-portion which
   (a) is spaced apart from the main portion of the device,
   (b) comprises a second distal sub-part of the second leg part of the second electrode, and
   (c) comprises a second electrical connector which contacts the second distal sub-part of the second electrode and extends beyond the first face of the laminar resistive element; and
(ii) a second bridge sub-portion which
   (a) lies between the second distal sub-portion and the main portion of the device,
   (b) extends across the width of the second connection leg, and
   (c) does not include any part of the first electrode.

Preferably there is a solder joint between each of
(a) the first electrical connector and the first electrode,
(b) the first electrical connector and the first metal conductor, and
(c) the second electrode and the second metal conductor, or between the second electrode and an intermediate connector and between the intermediate connector and the second metal conductor, the intermediate connector lying between the second electrode and the second metal conductor.

### DETAILED DESCRIPTION OF THE DRAWING

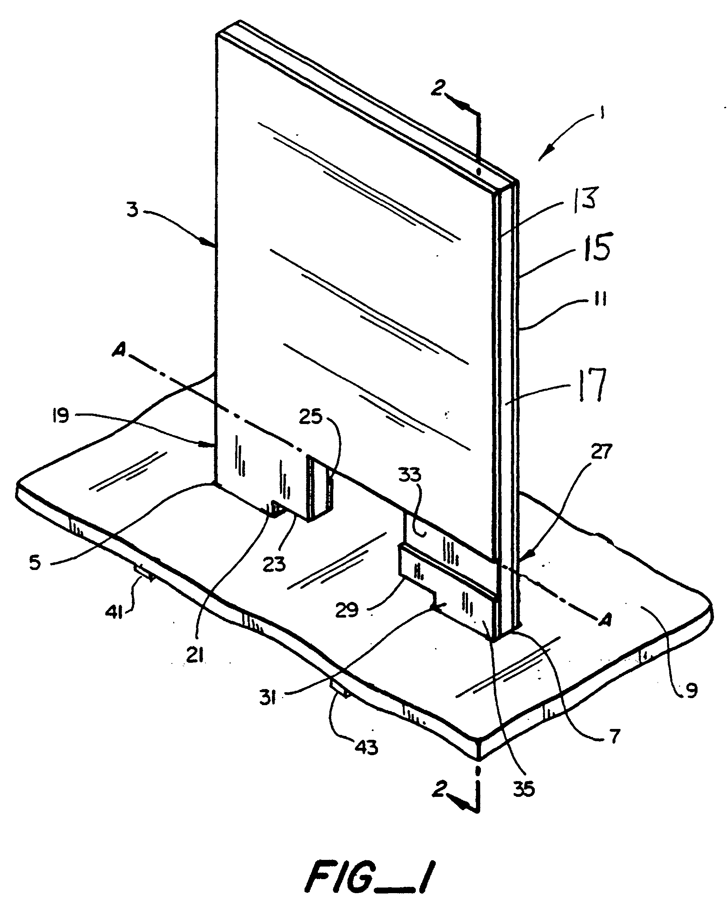

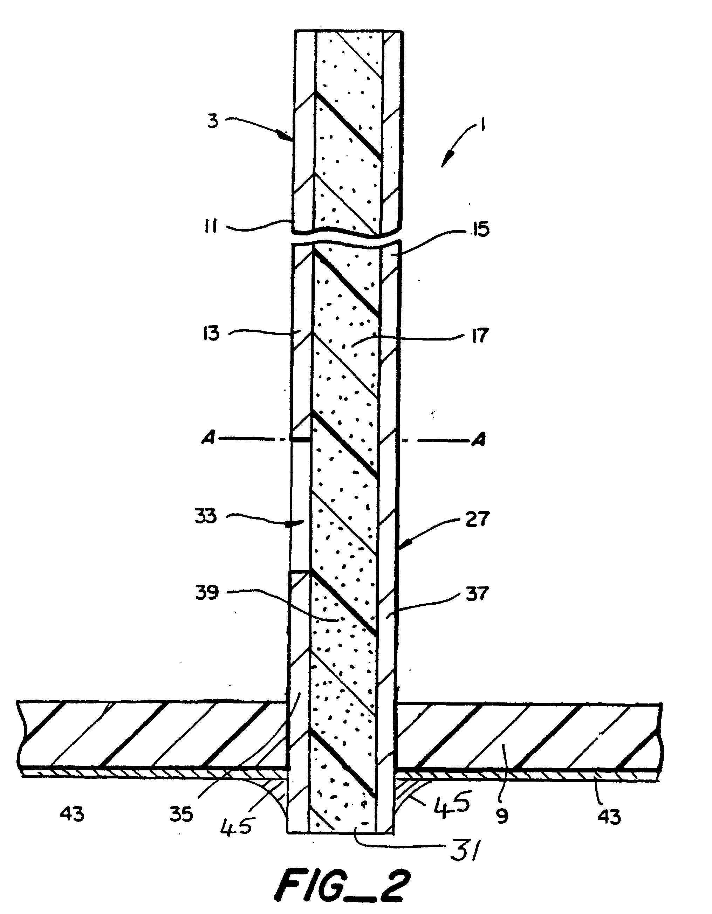

The invention is illustrated by the drawing in which Figure 1 shows an electrical assembly 1 of the invention and Figure 2 shows a cross-section of electrical assembly 1 along line 2-2 of Figure 1. In both Figures 1 and 2, an electrical device 3 of the invention is mounted into first aperture 5 and second aperture 7 on an insulating planar substrate 9, e.g. a circuit board. The section of electrical device 3 above line A-A is the train portion 11, in which the main part of the first laminar electrode 13 and the main part of the second laminar electrode 15, shown in these Figures as metal foil electrodes, are attached to the main part of the laminar resistive element 17, here a conductive polymer which exhibits PTC behavior. Device 3 comprises two connection legs 19 and 27 which are coplanar and extend away from main portion 11 and are used to insert device 3 into the substrate 9. First connection leg 19 comprises a first leg part of the first electrode and a first leg part of the resistive element. In addition, first connection leg 19 comprises a first distal sub-portion 21, a first stand-off sub-portion, shown here in the form of a step, and a first bridge sub-portion 25 (on the back surface of Figure 1). Second connection leg 27 comprises a second stand-off sub-portion 29, second distal sub-portion 31 which lies at least partly within the second aperture 7, and second bridge sub-portion 33. Second distal sub-portion 31 includes the second distal subpart of the second electrode and lies within the second aperture 7 of the substrate. As shown in Figure 2, below line A-A lie a first residual conductive member 35 which is part of the second connection leg 27, as well as the second leg part of the second electrode 37 and the second leg part of the resistive element 39. In order to make electrical contact to the electrical device 3, connection is made between the electrical device 3 and the first metal conductor 41, a conductive trace which leads to the first aperture and is secured to the substrate, and between the electrical device 3 and the second metal conductor 43 which leads to the second aperture and is secured to the substrate. As shown in Figure 2, solder 45 is used to make connection between second metal conductor 43 and the second laminar electrode 15, as well as between the second metal conductor 43 and the residual part of the electrode 13.

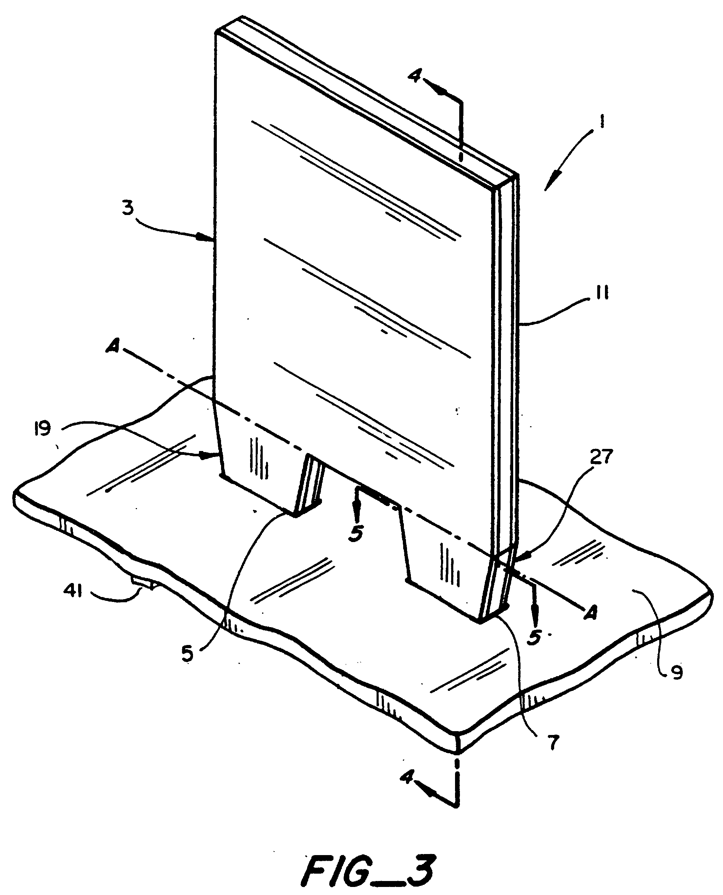

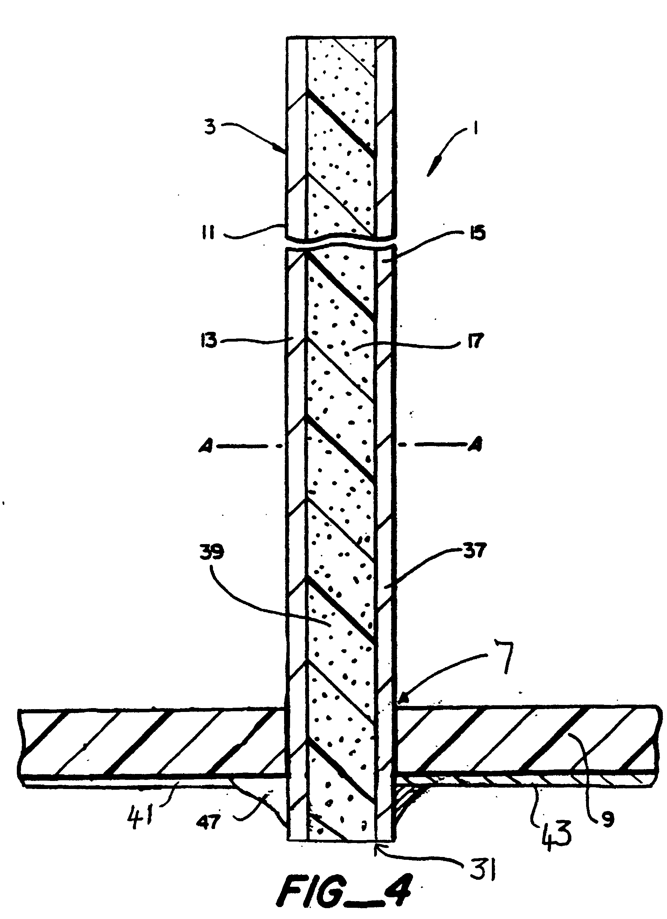

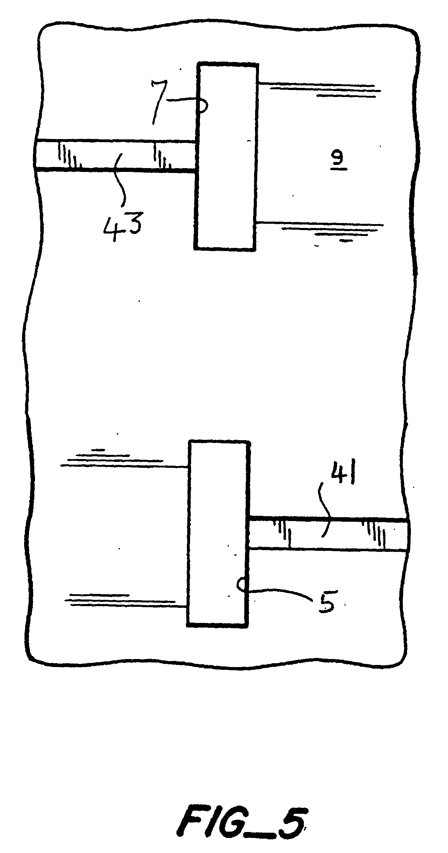

Figure 3 shows a plan view of another electrical assembly 1 of the invention, Figure 4 shows across-Section of electrical assembly 1 along line 4-4 of Figure 3, and Figure 5 is a bottom view of the assembly of Figure 3 along line 5-5 before and after insertion and electrical connection of a device of the invention. As shown in Figures 1 and 2, electrical device 3 is inserted onto insulating planar substrate 9 through first aperture 5 and second aperture 7 by means of first connection leg 19 and second connection leg 27, respectively. For this device, the first connection leg 19 and the second connection leg 27 are in the form of wedges, and neither a first bridge sub-portion nor a second bridge-sub-portion is present. In Figure 4, the second distal sub-portion 31 of the second connection leg 27 is visible, and, below line A-A, the second leg part of the first electrode 37 and the second leg part of the resistive element 39 are shown. First metal conductor 41 leads to and terminates on one side of first aperture 5, and second metal conductor 43 leads to and terminates on the opposite side of second aperture 7. As shown in Figure 4, electrical connection is made between the first laminar electrode 13 and the first metal conductor 43 by means of solder joint 47.

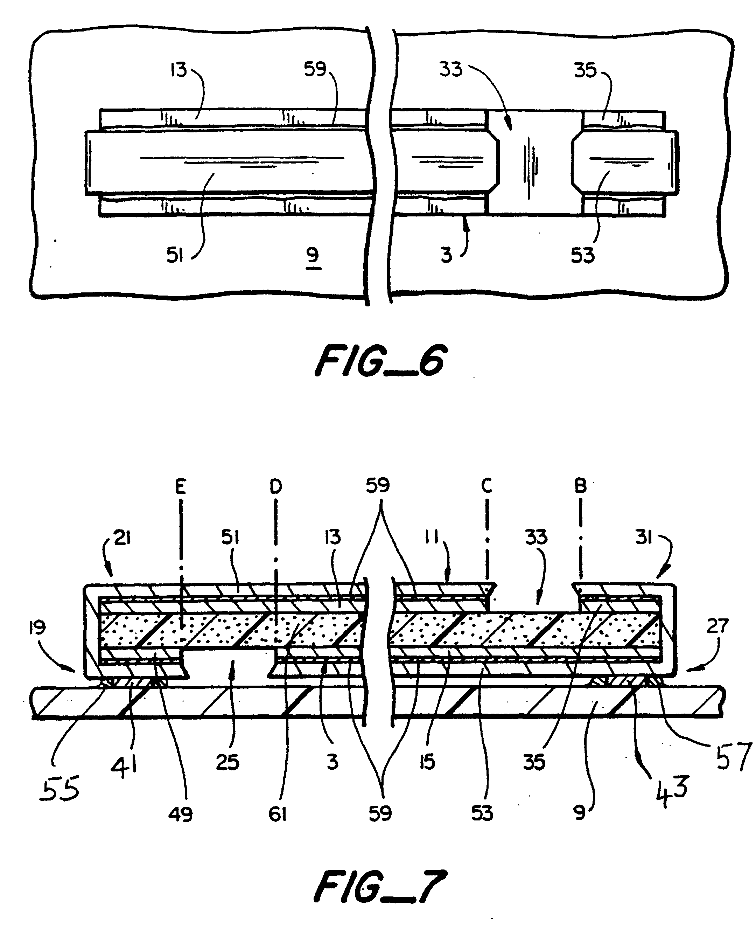

Figure 6 is a top view of another assembly 1 of the invention and Figure 7 is a cross-sectional view through the thickness of the assembly 1 in which the electrical device 3 is suitable for installing as a surface mounted device. In this assembly, the electrical device 3 comprises a laminar resistive element 61 which is laminated to the main portion of the first electrode 13 and the first residual conductive member 35 and to the main portion of the second electrode 15 and the second residual conductive member 49. (The main portion 11 of the device lies between lines C and D.) Attached to first connection leg 19 around first distal sub-portion 21 is U-shaped first connector 51. Attached to second connection leg 27 around second distal sub-portion 31 is U-shaped second connector 53. A solder joint 59 lies between the periphery of the first connector 51 and the first electrode 13 and between the periphery of the second connector 53 and the second electrode 15. First bridge sub-portion 25 lies between lines D and E and second bridge sub-portion 33 lies between lines B and C. Electrical connection is made from the first connector 51 to a first metal conductor 41 secured to insulating substrate 9 by means of first solder joint 55, and from the second connector 53 to second metal connector 43 secured to the insulating substrate 9 by means of second solder joint 57.

The invention is illustrated by the following Examples.

### Example 1

A conductive polymer composition was prepared by pre blending 48.6% by weight high density polyethylene (Petrothene LB832, available from USI) with 51.4% by weight carbon black (Raven 430, available from Columbian Chemicals). The blend was mixed in a Banbury mixer, and the resulting composition was extruded through a 63.5 mm (2.5 inch) extruder to form a sheet with a thickness of 0.51 mm (0.020 inch). Two sheets of extrudate were laminated together to give a sheet with a thickness of about 1 mm (0.040 inch). The sheet was laminated on each side with 0.025 mm (0.001 inch) thick electrodeposited nickel foil (available from Fukuda) and the laminate was irradiated to a dose of 10 Mrad using a 4.5 MeV electron beam. An electrical device with a shape as shown in Figure 1 was cut from the irradiated sheet. The main portion had a width of approximately 7.75 mm (0.305 inch) and a length of approximately 19.7 mm (0.775 inch). The first connection leg and the second connection leg each had a length of 5.25 mm (0.207 inch). There was a maximum distance between the first and second connection legs at the first and second distal sub-portions of 3.8 mm (0.150) inch, and a distance between the step of the first standoff sub-portion and the step of the second standoff sub-portion of 2.0 mm (0.080 inch). The length of the first bridge sub-portion on the first connection leg and of the second bridge sub-portion on the second connection leg was 1.27 mm (0.05 inch). The first and second bridge sub-portions were created by scoring the nickel foil and peeling it completely away from the conductive polymer resistive element

The first and second connection legs of the electrical device were inserted into first and second apertures, respectively, of a printed circuit board to form an assembly. The assembly was then wave-soldered, causing the electrical traces on the circuit board leading to the first and second apertures to be connected by solder to the first and second connection legs, respectively, as shown in Figure 2. Solder completely surrounded the first and second connection legs.

### Example 2

A conductive polymer composition was mixed, extruded, laminated, and irradiated as in Example 1. An electrical device with a shape as shown in Figure 3 was cut from the irradiated sheet. The main portion had a width of approximately 7.8 mm (0.307 inch) and a length of 21 mm (0.827 inch). The first and second leg portions each had a length of 4 mm (0.157 inch) and tapered from a maximum of *2.5* mm (0.098 inch) at the junction with the main portion to a minimum of 1.75 mm (0.068 inch) at the first distal sub-portion and the second distal sub-portion. No bridge sub-portions were created.

The first and second connection legs of the electrical device were inserted into first and second apertures, as in Example 1. In this case, however, the electrical traces on the circuit board made contact with only one of the electrodes. Thus when the assembly was subjected to wave soldering, only one side of the device was electrically connected to each of the traces, as shown in Figures 4 and 5.

## Claims

1. A circuit protection device having a resistance at 23°C of less than 50 ohms, which comprises
(1) a first laminar metal foil electrode (13);
(2) a second laminar metal foil electrode (15); and
(3) a laminar resistive element (61) which is composed of a PTC conductive polymer, and which has a first face to which the first electrode is secured and an opposite second face to which the second electrode is secured;
the device comprising
(a) a main portion (11, C-D) which comprises
(i) a main part of the first electrode (13),
(ii) a main part of the second electrode (15), and
(iii) a main part of the resistive element (61); and
(b) a first connection leg (19) which extends away from the main portion and which comprises
(i) a first leg part of the first electrode (13) which is integral with the main part of the first electrode (13), and
(ii) a first leg part of the resistive element (61) which is integral with the main part of the resistive element (61);
said first connection leg (19) comprising
(i) a first distal sub-portion (21) which
(a) is spaced away from the main portion of the device,
(b) comprises a first distal sub-part of the first leg part of the first electrode (13),
(c) comprises a first electrical connector (51) which contacts the first distal sub-part of the first electrode and extends at least to the second face of the laminar resistive element (61), and
(d) comprises a second residual conductive member (49) which is on the second face of the first leg part of the resistive element (61), and
(ii) a first bridge sub-portion (25, D-E) which
(a) lies between the first distal sub-portion (21) and the main portion (11, C-D) of the device,
(b) extends across the width of the first connection leg, and
(c) does not include any part of the second electrode (15);
the second residual conductive member (49) being a member which is separated from the second electrode (15) and which, in the absence of the first bridge sub-portion (25, D-E), would be integral with the second electrode;
whereby the device can be placed flat on a planar insulating substrate (9) having first and second appropriately spaced-apart metal conductors (41,43) on the surface thereof, with the first electrical connector (51) against the first metal conductor (41); and electrical connection can be made (a) between the first metal conductor (41) and the first electrode (13), through the first electrical connector (51), and (b) between the second conductor (43) and the second electrode (15),
and wherein said device is made by a process which comprises
(1) cutting a plurality of devices from a laminate comprising a sheet of PTC conductive polymer between two metal foils, and
(2) removing unwanted portions of at least one metal foil from the device to form the first bridge sub-portion (25).

2. A device according to claim 1 which also contains
(c) a second connection leg (27) which extends away from the main portion (11, C-D) of the device, which is spaced away from the first connection leg, and which comprises
(i) a second leg part of the second electrode (15) which is integral with the main part of the second electrode, and
(ii) a second leg part of the resistive element (61) which is integral with the main part of the resistive element (61)
said second connection leg (27) comprising
(i) a second distal sub-portion (31) which
(a) is spaced away from the main portion (11, C-D) of the device,
(b) comprises a second distal sub-part of the first leg part of the second electrode (15), and
(c) comprises a second electrical connector (53) which contacts the second distal sub-part of the second electrode (15) and extends at least to the first face of the laminar resistive element (61), and
(ii) a second bridge sub-portion (33, B-C) which
(a) lies between the second distal sub-portion (31) and the main portion (11, C-D) of the device,
(b) extends across the width of the second connection leg (27),
(c) does not include any part of the first electrode (13), and
(d) comprises a first residual conductive member (35) which is on the first face of the second leg part of the resistive element (61),
whereby the device can be placed flat on a planar insulating substrate (9) having first and second appropriately spaced-apart metal conductors (41,43) on the surface thereof, with the first electrical connector (51) or the second electrical connector (53) against one of the metal conductors, and electrical connection can be made between (a) said electrical connector and metal conductor, and (b) the other metal conductor and the electrode adjacent the substrate.

3. A device according to claim 2 wherein an unwanted portion of metal foil is removed to form the second bridge sub-portion.

4. A device according to claim 1 or 3 wherein the unwanted portions of metal foil are removed before the device is cut from the laminate.

5. A device according to claim 1 or 3 wherein the unwanted portions of metal foil are removed after the device is cut from the laminate.

6. A device according to claim 1 wherein the first electrical connector (51) is a U-shaped member (51) which extends around the end of the first connection leg (19) and contacts the first electrode (13) and the second residual conductive member (49).

## Patentansprüche

1. Schaltungsschutzvorrichtung, die bei 23 °C einen Widerstand von weniger als 50 Ohm besitzt und folgendes aufweist:
(1) eine erste Metallfolienlaminat-Elektrode (13);
(2) eine zweite Metallfolienlaminat-Elektrode (15); und
(3) ein laminatförmiges Widerstandselement (61), das aus einem leitenden PTC-Polymer gebildet ist und eine erste Fläche, an der die erste Elektrode befestigt ist, sowie eine gegenüberliegende zweite Fläche besitzt, an der die zweite Elektrode befestigt ist;
wobei die Vorrichtung folgendes aufweist:
(a) einen Hauptbereich (11, C-D), der folgendes aufweist:
(i) ein Hauptteil der ersten Elektrode,
(ii) ein Hauptteil der zweiten Elektrode (15) und
(iii) ein Hauptteil des laminatförmigen Widerstandselements (61); und
(b) einen ersten Verbindungsschenkel (19), der sich von dem Hauptbereich aus erstreckt und folgendes aufweist:
(i) ein erstes Schenkelteil der ersten Elektrode (13), das integral mit dem Hauptteil der ersten Elektrode (13) ausgebildet ist, und
(ii) ein erstes Schenkelteil des laminatförmigen Widerstandselements (61), das integral mit dem Hauptteil des laminatförmigen Widerstandselements (61) ausgebildet ist;
wobei der erste Verbindungsschenkel (19) folgendes aufweist:
(i) einen ersten distalen Unterbereich (21), der
(a) von dem Hauptbereich der Vorrichtung beabstandet ist,
(b) ein erstes distales Unterteil des ersten Schenkelteils der ersten Elektrode (13) aufweist,
(c) einen ersten elektrischen Verbinder (51) aufweist, der mit dem ersten distalen Unterteil der ersten Elektrode in Kontakt steht und sich zumindest zu der zweiten Fläche des laminatförmigen Widerstandselements (61) erstreckt, und
(d) ein zweites restliches leitendes Element (49), das sich an der zweiten Fläche des ersten Schenkelteils des laminatförmigen Widerstandselements (61) befindet, und
(ii) einen ersten Brückenunterbereich (25, D-E), der
(a) zwischen dem ersten distalen Unterbereich (21) und dem Hauptbereich (11, C-D) der Vorrichtung liegt,
(b) sich über die Breite des ersten Verbindungsschenkels erstreckt und
(c) keinerlei Teil der zweiten Elektrode (15) enthält;
wobei das zweite restliche leitende Element (49) ein Element ist, das von der zweiten Elektrode (15) getrennt ist und das beim Fehlen des ersten Brückenunterbereichs (25, D-E) mit der zweiten Elektrode integral ausgebildet wäre;
wobei die Vorrichtung flach auf einem ebenen Isoliersubstrat (9) angeordnet sein kann, das auf seiner Oberfläche einen ersten und einen zweiten geeignet beabstandeten Metalleiter (41, 43) besitzt, wobei der erste elektrische Verbinder (51) gegen den ersten Metalleiter (41) anliegt; und wobei eine Verbindung hergestellt werden kann (a) zwischen dem ersten Metalleiter (41) und der ersten Elektrode (13) über den ersten elektrischen Verbinder (51), und (b) zwischen dem zweiten Leiter (43) und der zweiten Elektrode (15), und
wobei die Vorrichtung durch einen Prozess hergestellt wird, der folgendes aufweist:
(1) Ausschneiden mehrerer Vorrichtungen aus einem Laminat, das eine Lage aus einem leitenden PTC-Polymer zwischen zwei Metallfolien aufweist, und
(2) Entfernen unerwünschter Bereiche von mindestens einer Metallfolie von der Vorrichtung, um den ersten Brückenunterbereich (25) zu bilden.

2. Vorrichtung nach Anspruch 1, die außerdem folgendes aufweist:
(c) einen zweiten Verbindungsschenkel (27), der sich von dem Hauptbereich (11, C-D) der Vorrichtung aus erstreckt, von dem ersten Verbindungsschenkel beabstandet ist und folgendes aufweist:
(i) ein zweites Schenkelteil der zweiten Elektrode (15), das integral mit dem Hauptteil der zweiten Elektrode ausgebildet ist, und
(ii) ein zweites Schenkelteil des laminatförmigen Widerstandselements (61), das integral mit dem Hauptteil des laminatförmigen Widerstandselements (61) ausgebildet ist,
wobei der zweite Verbindungsschenkel (27) folgendes aufweist:
(i) einen zweiten distalen Unterbereich (31), der
(a) von dem Hauptbereich (11, C-D) der Vorrichtung beabstandet ist,
(b) ein zweites distales Unterteil des ersten Schenkelteils der zweiten Elektrode (15) aufweist und
(c) einen zweiten elektrischen Verbinder (53) aufweist, der mit dem zweiten distalen Unterteil der zweiten Elektrode (15) in Kontakt ist und sich zumindest zu der ersten Fläche des laminatförmigen Widerstandselements (61) erstreckt, und
(ii) einen zweiten Brückenunterbereich (33, B-C), der
(a) zwischen dem zweiten distalen Unterbereich (31) und dem Hauptbereich (11, C-D) der Vorrichtung liegt,
(b) sich über die Breite des zweiten Verbindungsschenkels (27) erstreckt,
(c) keinerlei Teil der ersten Elektrode (13) enthält und
(d) ein erstes restliches leitendes Element (35) aufweist, das sich an der ersten Fläche des zweiten Schenkelteils des laminatförmigen Widerstandselements (61) befindet,
wobei die Vorrichtung flach auf einem ebenen Isoliersubstrat (9) angeordnet sein kann, das auf seiner Oberfläche einen ersten und einen zweiten geeignet beabstandeten Metalleiter (41, 43) besitzt, wobei der erste elektrische Verbinder (51) oder der zweite elektrische Verbinder (53) gegen einen der Metalleiter anliegt und wobei eine elektrische Verbindung hergestellt werden kann zwischen (a) dem elektrischen Verbinder und dem Metalleiter, und (b) dem anderen Metalleiter und der an das Substrat angrenzenden Elektrode.

3. Vorrichtung nach Anspruch 2,
bei der ein unerwünschter Bereich der Metallfolie entfernt wird, um den zweiten Brückenunterbereich zu bilden.

4. Vorrichtung nach Anspruch 1 oder 3,
bei der die unerwünschten Bereiche von Metallfolien entfernt werden, bevor die Vorrichtung aus dem Laminat ausgeschnitten wird.

5. Vorrichtung nach Anspruch 1 oder 3,
bei der die unerwünschten Bereiche der Metallfolie entfernt werden, nachdem die Vorrichtung aus dem Laminat ausgeschnitten worden ist.

6. Vorrichtung nach Anspruch 1,
bei der der erste elektrische Verbinder (51) ein U-förmiges Element (51) ist, das sich um das Ende des ersten Verbindungsschenkels (19) erstreckt und mit der ersten Elektrode (19) sowie mit dem zweiten restlichen leitenden Element (49) in Kontakt steht.

## Revendications

1. Dispositif de protection de circuit ayant une résistance à 23° C inférieure à 50 ohms, qui comprend
(1) une première électrode (13) à feuille métallique lamellaire ;
(2) une seconde électrode (15) à feuille métallique lamellaire ; et
(3) un élément résistif lamellaire (61) qui est composé d'un polymère conducteur CTP, et qui a une première face à laquelle la première électrode est fixée et une seconde face opposée à laquelle la seconde électrode est fixée ;
le dispositif comprenant
(a) une partie principale (11, C-D) qui comprend
(i) une partie principale de la première électrode (13) ;
(ii) une partie principale de la seconde électrode (15), et
(iii) une partie principale de l'élément résistif (61) ;
(b) une première jambe de connexion (19) qui s'étend à l'opposé de la partie principale et qui comprend
(i) une première partie de jambe de la première électrode (13) qui est solidaire de la partie principale de la première électrode (13), et
(ii) une première partie de jambe de l'élément résistif (61) qui est solidaire de la partie principale de l'élément résistif (61) ;
ladite première jambe de connexion (19) comprenant
(i) une première sous-partie distale (21) qui
(a) est espacée de la partie principale du dispositif,
(b) comprend une première sous-partie distale de la première partie de jambe de la première électrode (13),
(c) comprend un premier connecteur électrique (51) qui vient en contact avec la première sous-partie distale de la première électrode et s'étend au moins vers la seconde face de l'élément résistif lamellaire (61), et
(d) comprend un second élément conducteur résiduel (49) qui se trouve sur la seconde face de la première partie de jambe de l'élément résistif (61), et
(ii) une première sous-partie de pont (25, D-E) qui
(a) se situe entre la première sous-partie distale (21) et la partie principale (11, C-D) du dispositif,
(b) s'étend à travers la largeur de la première jambe de connexion, et
(c) n'inclut aucune partie de la seconde électrode (15) ;
le second élément conducteur résiduel (49) étant un élément qui est séparé de la seconde électrode (15) et qui, en l'absence de la première sous-partie de pont (25, D-E), serait solidaire de la seconde électrode ;
avec pour effet que le dispositif peut être placé à plat sur un substrat isolant plan (9) ayant des premier et second conducteurs (41, 43) métalliques espacés de manière appropriée sur la surface de celui-ci, avec le premier connecteur électrique (51) contre le premier conducteur métallique (41) ; et une connexion électrique peut être effectuée (a) entre le premier conducteur métallique (41) et la première électrode (13), à travers le premier connecteur électrique (51), et (b) entre le second conducteur (43) et la seconde électrode (15),
et dans lequel ledit dispositif est fabriqué par un procédé qui consiste à
(1) découper une pluralité de dispositifs à partir d'un stratifié comprenant une feuille de polymère conducteur CTP entre deux feuilles métalliques, et
(2) enlever les parties non désirées d'au moins une feuille métallique du dispositif pour former la première sous-partie de pont (25).

2. Dispositif selon la revendication 1, qui contient également
(c) une seconde jambe de connexion (27) qui s'étend à l'opposé de la partie principale (11, C-D) du dispositif, qui est espacée de la première jambe de connexion, et qui comprend
(i) une seconde partie de jambe de la seconde électrode (15) qui est solidaire de la partie principale de la seconde électrode, et
(ii) une seconde partie de jambe de l'élément résistif (61) qui est solidaire de la partie principale de l'élément résistif (61)
ladite seconde jambe de connexion (27) comprenant
(i) une seconde sous-partie distale (31) qui
(a) est espacée de la partie principale (11, C-D) du dispositif,
(b) comprend une seconde sous-partie distale de la première partie de jambe de la seconde électrode (15), et
(c) comprend un second connecteur électrique (53) qui vient en contact avec la seconde sous-partie distale de la seconde électrode (15) et s'étend au moins vers la première face de l'élément résistif lamellaire (61), et
(ii) une seconde sous-partie de pont (33, B-C) qui
(a) se situe entre la seconde sous-partie distale (31) et la partie principale (11; C-D) du dispositif,
(b) s'étend à travers la largeur de la seconde jambe de connexion (27),
(c) n'inclut aucune partie de la première électrode (13), et
(d) comprend un premier élément conducteur résiduel (35) qui se trouve sur la première face de la seconde partie de jambe de l'élément résistif (61),
avec pour effet que le dispositif peut être placé à plat sur un substrat isolant plan (9) ayant des premier et second conducteurs (41, 43) métalliques espacés de manière appropriée sur la surface de celui-ci, avec le premier connecteur électrique (51) ou le second connecteur électrique (53) contre l'un des conducteurs métalliques, et une connexion électrique peut être effectuée entre (a) ledit connecteur électrique et le conducteur métallique, et (b) l'autre conducteur métallique et l'électrode adjacente au substrat.

3. Dispositif selon la revendication 2, dans lequel une partie non désirée de la feuille métallique est enlevée pour former la seconde sous-partie de pont.

4. Dispositif selon la revendication 1 ou 3, dans lequel les parties non désirées de la feuille métallique sont enlevées avant que le dispositif ne soit découpé à partir du stratifié.

5. Dispositif selon la revendication 1 ou 3, dans lequel les parties non désirées de la feuille métallique sont enlevées après que le dispositif est découpé à partir du stratifié.

6. Dispositif selon la revendication 1, dans lequel le premier connecteur électrique (51) est un élément (51) en forme de U qui s'étend autour de l'extrémité de la première jambe de connexion (19) et vient en contact avec la première électrode (13) et le second élément conducteur résiduel (49).
